Europäisches Patentamt

European Patent Office

Office européen des brevets

(11) Publication number: **0 598 146 A1**

# EUROPEAN PATENT APPLICATION

(21) Application number: **92203507.6**

(51) Int. Cl.5: **H01L 27/02**

(22) Date of filing: **16.11.92**

(43) Date of publication of application:
**25.05.94 Bulletin 94/21**

(84) Designated Contracting States:
**AT BE CH DE DK ES FR GB GR IE IT LI LU MC NL PT SE**

(71) Applicant: **ALCATEL N.V.**
**Strawinskylaan 341,**
**(World Trade Center)**
**NL-1077 XX Amsterdam(NL)**
Applicant: **BELL TELEPHONE MANUFACTURING COMPANY Naamloze Vennootschap**
**Francis Wellesplein 1**
**B-2018 Antwerp(BE)**

(72) Inventor: **Maene, Nora Alice Raoul**
**Dumortierlaan 20**
**B-8300 Knokke-Heist(BE)**
Inventor: **Vandenbroeck, Josiane Ann Marie**
**Diestburgstraat 137**
**B-3071 Kortenberg(BE)**

(74) Representative: **Vermeersch, Robert**
**BELL TELEPHONE MANUFACTURING COMPANY**
**Naamloze Vennootschap**
**Patent Department**
**Francis Wellesplein 1**
**B-2018 Antwerpen (BE)**

(54) Protection device against electrostatic discharges.

(57) An electrostatic discharge (ESD) protection device protecting an integrated circuit (IC) from an ESD into a terminal pair (TERM, VSS) thereof is presented. It consists of an insulated gate field effect transistor (TR) which is diode connected across the terminal pair (TERM, VSS), has a turn-on voltage (VPT) low enough not to damage the output (TERM, VSS), and comprises:
- a substrate (SUB) of a first conductivity type (p), wherein
- a source region (SW, ST) and a drain region (DW, DT) both of a second conductivity type (n) and separated by a channel region (CH);
- an insulating layer (INS, FOX) covering the substrate (SUB) with a thicker portion having a breakdown voltage larger than said turn-on voltage (VPT) covering the channel region (CH);
- a gate covering the insulating layer thicker portion and part of the insulating layer (INS, FOX) covering the source region (SW, ST).

FIG.1

The present invention relates to an electrostatic discharge (ESD) protection device for protecting an integrated circuit against an ESD occurring across a terminal pair thereof, and comprising an insulated gate field effect transistor which is diode connected across said terminal pair, said transistor having a turn-on voltage smaller than a voltage which damages said integrated circuit when applied across said terminal pair, and comprising:
- a substrate of a first conductivity type (p);
- in said substrate a source region and a drain region which are of a second conductivity type (n) and are separated by a channel region;
- an insulating layer covering said substrate and a thicker portion of which covers said channel region, said thicker portion having a breakdown voltage larger than said turn-on voltage; and
- a gate covering said insulating layer thicker portion.

Such an ESD protection device is generally known in the art as a thick oxide device (TOD) structure. It is described e.g. in the published European patent application nr 0217525A1. When the ESD occurs across the terminal pair of the integrated circuit the TOD structure turns on - supposing the ESD is large enough -, thereby providing across this terminal pair a shunt path, allowing the electrostatic charges to flow via before a voltage, built up by these charges over a spurious capacitance present across the terminal pair of the integrated circuit, can damage the latter circuit. As is known in the art, a diode connected transistor normally turns on when the voltage between the gate and the source region (VGS) reaches a so-called threshold value. Since the insulating layer portion below the gate is relatively thick this threshold value is relatively large for the TOD structure. Thus, in principle the TOD structure would only turn on for a higher VGS. However, since in our case VGS is equal to the voltage between the drain region and the source region (VDS), due to punch-through the TOD structure already turns on for a lower VDS or VGS, as explained hereinafter.

As is known in the art, at a junction between a p-type region and an n-type region which is externally not biased, a region deprived from so-called free charges, i.e. electrons and holes, is formed. Such a region is also referred to as a space charge layer. A voltage also referred to as built-in voltage then occurs across this space charge layer. When an external voltage reversely biasing the junction is applied, the space charge layer spreads and the sum of the external and the built-in voltages occurs completely over the space charge layer.

VDS - assumed positive - is present across the series connection of the junction between the source region and the substrate, and the junction between the substrate and the drain region, which is reversely biased by it. Since no current can flow through the reversely biased drain region-substrate junction, no current flows through the source region-substrate junction as well. The voltage standing over the latter junction is approximately zero, and VDS appears substantially completely over the drain region-substrate junction. To be noted that a small space charge layer still exists at the source region-substrate junction.

When VDS increases, the voltage across the junction between the drain region and the substrate also increases so that the space charge layer at this junction spreads. When it has spread to such extent that it touches the space charge layer at the junction between the source region and the substrate, punch-through occurs. At that point VDS which initially was completely standing over the drain region-substrate space charge layer, as mentioned above, forwardly biases the source region-substrate junction over which initially approximately no voltage was standing, as also mentioned above. As a consequence the source, defined by the source region, starts acting as an emitter of a parasitic bipolar transistor, thereby injecting majority carriers - electrons in case of an n-type source region - into the channel region which then acts as a base of the same bipolar transistor. These carriers are swept through the channel region - where they now represent minority carriers - by the electric field created by VDS and are collected in the drain region thus acting as a collector of the parasitic transistor. In this way a current starts flowing once VDS ( = VGS) reaches a punch-through voltage (VPT) causing the above mentioned space charge layers to come into contact.

VPT must be sufficiently low since punch-through is to occur before damage to the integrated circuit can take place, i.e. before destruction thereof due to junction breakdown, contact failure or breakdown of the oxide layers. Moreover, the smaller the components on the integrated circuit, i.e. the larger the integration scale of the integrated circuit, the lower the breakdown voltages and the easier these components can be damaged.

A problem associated with punch-through is that the parameter VPT is difficult to be controlled. As is known in the art and shown in the following equation, in a first order model VPT is approximately proportional to the doping level of the substrate (NB) and to the square of the channel length (L$^2$). $q$ is the electron charge, $\epsilon$ is the permittivity of the substrate and $\phi$ is the built-in voltage associated to the source region-substrate junction.

$$VPT = \frac{q \times NB \times L^2}{2\varepsilon} - \phi$$

NB is a parameter which is the same for the whole of a given integrated circuit and should therefore not be used as a design parameter for tuning the VPT of the TOD structure. To be noted that NB could be locally adapted at the site of the TOD structure by e.g. ion implantation so that it could all the same be used as a design parameter, but this would require an extra process step - and an expensive extra mask - in the manufacturing of the integrated circuit and would hence increase manufacturing costs.

On the other hand, $L^2$ cannot be made arbitrarily small since to be grown the thick insulating layer part requires a certain lateral space, i.e. when this thick part is grown lateral spreading thereof is unavoidable and causes the creation of a so-called birds-beak well known in the art.

It is to be noted that the protection of an integrated circuit against an ESD event is particularly required during handling thereof since a person touching the integrated circuit is very likely to cause an ESD into a terminal pair of the integrated circuit. On the other hand, when the integrated circuit is in operation the ESD protection device should not be allowed to be turned on at voltages within the normal output range of the terminal pair of the integrated circuit. In the first case a low VPT is necessary, whereas in the second case a high VPT is required. As is described in the above mentioned published European patent application, this dilemma can be solved by choosing a low VPT and by less reversely biasing the substrate with respect to the source region so that the source region-substrate junction space charge layer reduces, thereby increasing VPT of the ESD protection device. In the above mentioned published European patent application this is referred to as back biasing of the integrated circuit.

An object of the present invention is to provide an ESD protection device of the above kind, but whose turn-on voltage can be adapted in a different way without increasing manufacturing costs.

This object is achieved due to the fact that said gate also covers part of the portion of said insulating layer covering said source region.

The gate thus extends over part of the source region and this extension can be easily implemented by adapting one mask in the manufacturing process of the integrated circuit, viz. the mask defining the gate - i.e. e.g. the gate metal. Hence, as no additional steps are introduced in the manufacturing process, manufacturing costs are not increased compared to an implementation with a not extended gate.

The effect of the extension of the gate over part of the source region on the operation of the ESD protection device is as follows. When VDS increases, the voltage over the junction between the drain region and the substrate increases, thus spreading the accompanying space charge layer as before. However, since the gate extends over part of the source region VDS also reversely biases the junction between the source region and the channel region thus spreading the accompanying space charge layer. Thereby, the voltage VPT needed for the two space charge layers to come into contact is decreased. Hence, by adjusting the width of the extension, VPT can be adapted.

It is to be noted that the extension causes VGS to be partly applied over a thinner portion of the insulating layer, viz. a portion of the insulating layer covering the source region, thus lowering the breakdown voltage of the ESD protection device. Furthermore, the larger the extension, the greater the risk for an early breakdown due to impurities in the insulating layer thinner portion which are unavoidable. Therefore, the width of the extension must be designed so as to still provide low enough a risk for such an early breakdown.

It is also to be noted that in practice and for a field effect transistor normally used and thus not having a thicker oxide portion as in the above mentioned device, a small extension of the gate over the source region - in literature generally referred to as source region since the term 'well' is generally applied for low doped regions forming a transition between the actual source region and the substrate, such low doped regions not being present in this normally used field effect transistor - is unavoidable because of lateral underdiffusion of the source under the gate, such extension introducing an additional parasitic capacitance between the gate and the source. A like parasitic capacitance is also present between the gate and the drain but is of no importance for the considerations made since the gate and the drain of the TOD structure are interconnected. In generic circuit design these capacitances, virtually multiplied because of the so-called Miller effect well known in the art, have a negative effect on circuit performance and therefore, are to be avoided as much as possible by self-aligning the source and drain regions to the gate. This self-alignment is obtained by forming the source and drain diffusions by ion implantation while the channel and the gate oxide is e.g. covered with a polysilicon gate preventing the ions from being implanted below the gate. However, the Miller effect only occurs when ac signals are applied and is therefore not a factor to account for when the integrated circuit is not in operation, i.e. when the danger for damage through an ESD event is especially critical. Therefore the extension does not need to be avoided in the present structure but is applied as a parameter in tuning the turn-on voltage of the ESD protection device.

It should be noted that by using the principles of the invention, i.e. by adapting the width of the extension, VPT can be so tuned that back biasing of the integrated circuit as mentioned above is no longer necessary.

The above mentioned and other objects and features of the invention will become more apparent and the invention itself will be best understood by referring to the following description of an embodiment taken in conjunction with the accompanying drawings wherein :

Fig. 1 shows a cross-section of an ESD protection device according to the invention, and

Fig. 2 represents a configuration with an integrated circuit IC protected by the ESD protection device of Fig 1.

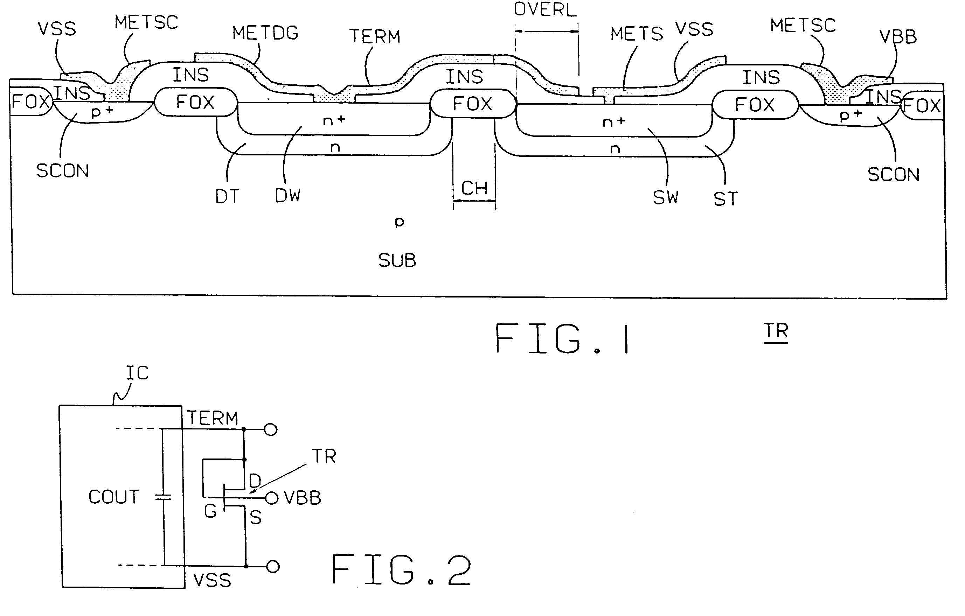

The ESD protection device shown in Fig. 1 consists of an insulated gate field effect transistor TR which comprises:

- a substrate or bulk SUB of p-conductivity type, and in which are embedded
- a source well region SW and a drain well region DW both of n-conductivity type;
- a substrate contact region SCON of the p-conductivity type but with a higher doping concentration (p+) than the substrate SUB; SCON is arranged around the actual field effect transistor and is, together with a (not shown) n+ guard ring around SCON, used for latch up prevention as known in the art; due to the higher doping concentration the resistance for charges flowing through SCON is low;
- a source terminal region ST and a drain terminal region DT embedded in the source well region SW and the drain well region DW, and forming therewith a source region and a drain region, respectively. ST and DT define a source S and a drain D of the transistor TR respectively, and are also of the n-conductivity type but with a higher doping concentration (n+) than the well regions SW and DW;
- a channel region CH in the substrate SUB located between the source well region SW and the drain well region DW;
- a relatively thick field oxide insulating layer FOX covering the portions of the substrate SUB located between the source terminal region ST and the drain terminal region DT, between these regions and the substrate contact region SCON, and between SCON and the rest of the integrated circuit IC;
- a dielectric insulating layer INS covering the substrate SUB and all doped regions formed in it, and the field oxide insulating layer FOX, i.e. INS covers the whole of the structure described sofar;

- a metal layer covering the dielectric insulating layer INS and including a source metal layer electrode METS and a drain-gate metal layer electrode METDG making contact with the source terminal region ST and the drain terminal region DT respectively, through contact windows in the insulating layer INS; the drain-gate metal layer METDG covers the drain well region DW and extends over a gate - referred to with G in Fig. 2; this gate covers the channel region CH and, for a distance OVERL, the source terminal region ST;
- the metal layer also includes a substrate contact metal layer METSC covering the dielectric insulating layer INS and making contact with the substrate contact region SCON. At each junction between an n- and a p-type semiconductor, when it is not forwardly biased, a so-called space charge layer can be formed, which is a region deprived of free charge, i.e. electrons and holes.

The ESD protection device TR of Fig. 1 is connected across a terminal pair TERM, VSS of the integrated circuit IC, as shown in Fig. 2. The interconnected drain D and gate G of TR are connected to a first terminal TERM of the terminal pair, whereas the source S is connected to a second terminal VSS of the terminal pair which during operation is biased at a like named ground reference voltage VSS. During operation the substrate or bulk is biased at a back bias voltage VBB which is equal to VSS, i.e. METS and METSC are interconnected. To be noted that VBB may be different from VSS as will be explained hereinafter. COUT is a spurious output capacitance present across the terminal pair TERM, VSS.

The device operates according to the punch-through principle. When a negative ESD occurs across the terminal pair TERM, VSS, i.e. when TERM is negatively biased by the ESD with respect to VSS, then the diode formed by the drain region-substrate junction is forwardly polarized and the charges of the ESD flow to VSS via METSC and SCON which provides a low resistance path for the charges due to the p+-diffusion of SCON. When a positive ESD occurs across COUT, a voltage which is applied between the gate G and the source S of the ESD protection device TR, is gradually built up across COUT by the electrostatic charges. When the latter voltage which also constitutes the drain-source voltage of the transistor TR, increases because of an ESD event, the space charge layer at the reversely biased junction between the drain well region DW and the channel region CH spreads. However, since the drain-gate metal layer METDG extends over the source terminal region ST for the distance OVERL, also the space charge layer at the junction between the source well region SW and the substrate SUB spreads. When both mentioned space charge layers make contact, punch-through occurs, thereby providing a path for the electrostatic charge to flow through. Thus, this charge no longer builds up the voltage across COUT.

To be noted that when METDG does not extend over the source terminal region ST - the distance OVERL is then zero -, a small effect still exists in case of an extension over SW but, assuming SW is only lightly doped, i.e. less than ST, this effect is smaller than that due to an extension over ST.

The distance OVERL is optimized so as to provide a sufficiently low VPT while still ensuring a low risk for an early breakdown of the insulating layer INS underneath the gate due to impurities in the thinner portion thereof, which are unavoidable.

To be noted that the ESD protection device described hereinbefore is generally used in conjunction with a so-called field plated diode as described for instance in the article "A synthesis of ESD input protection scheme" by C. Duvvury and R. Rountree, EOS/ESD symposium proceedings, 1991, pp. 88 - 97.

The punch-through voltage VPT of the device should be sufficiently low to allow an ESD to flow through the drain-source pad of the device TR before damaging the integrated circuit IC. On the other hand, the punch-through voltage VPT needs to be sufficiently high to prevent the device from being turned on during normal operation. This dilemma is solved in that by using the principles of the invention, VPT can be tuned in such a way that both above requirements are met.

It should however be noted that the dilemma may also be solved by less reversely biasing the substrate with respect to the source terminal region so that the source terminal region-substrate junction space charge layer reduces, so increasing the punch-through voltage VPT. As the integrated circuit IC is not biased when not in operation, e.g. during handling of the integrated circuit IC by a person, the punch-through voltage VPT is then lower.

While the principles of the invention have been described above in connection with specific apparatus, it is to be clearly understood that this description is made only by way of example and not as a limitation on the scope of the invention.

**Claims**

1. Electrostatic discharge (ESD) protection device for protecting an integrated circuit (IC) against an ESD occurring across a terminal pair (TERM, VSS) thereof, and comprising an insulated gate field effect transistor (TR) which is diode connected across said terminal pair (TERM, VSS), said transistor (TR) having a turn-on voltage (VPT) smaller than a voltage which damages said integrated circuit (IC) when applied across said terminal pair (TERM, VSS), and comprising:

- a substrate (SUB) of a first conductivity type (p);
- in said substrate (SUB) a source region (SW, ST) and a drain region (DW, DT) which are of a second conductivity type (n) and are separated by a channel region (CH);
- an insulating layer (INS, FOX) covering said substrate (SUB) and a thicker portion of which covers said channel region (CH), said thicker portion having a breakdown voltage larger than said turn-on voltage (VPT);
- a gate covering said insulating layer thicker portion;

characterized in that
said gate also covers part of the portion of said insulating layer (INS, FOX) covering said source region (ST).

FIG. 1

<u>TR</u>

FIG. 2

EP 0 598 146 A1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,Y | EP-A-0 217 525 (ADVANCED MICRO DEVICES)<br>* abstract; figure 2 * | 1 | H01L27/02 |
| Y | PATENT ABSTRACTS OF JAPAN<br>vol. 15, no. 135 (E-1052)4 April 1991<br>& JP-A-30 16 156 ( NISSAN ) 24 January 1991<br>* abstract * | 1 | |
| A | US-A-4 605 980 (HARTRANFT)<br>* column 5, line 50 - column 6, line 11; figure 4 * | 1 | |
| A | PATENT ABSTRACTS OF JAPAN<br>vol. 7, no. 182 (E-192)11 August 1983<br>& JP-A-58 087 877 ( SANYO ) 25 May 1983<br>* abstract * | 1 | |
| A | EP-A-0 462 040 (HELLO)<br>* abstract; figure 2 * | 1 | |
| A | PATENT ABSTRACTS OF JAPAN<br>vol. 10, no. 279 (E-439)20 September 1986<br>& JP-A-61 100 958 ( NEC ) 19 May 1986<br>* abstract * | 1 | TECHNICAL FIELDS SEARCHED (Int. Cl.5)<br><br>H01L |
| A | EP-A-0 087 155 (TOKYO SHIBAURA DENKI KABUSHIKI KAISHA)<br>* abstract; figures * | 1 | |

-----

The present search report has been drawn up for all claims

| Place of search | Date of completion of the search | Examiner |
|---|---|---|
| THE HAGUE | 07 JULY 1993 | VENDANGE P. |